# EUROPEAN PATENT APPLICATION

(11) **EP 4 672 551 A2**
(43) Date of publication of application: **31.12.2025**
(21) Application number: 25185554.0
(22) Date of filing: 26.06.2025
(51) Int. Cl.: H02J 7/00

(54) **SWITCH CIRCUIT, CIRCUIT FOR PROTECTING A BATTERY, METHOD AND CIRCUIT FOR CONTROLLING CHARGING, AND CHARGING SYSTEM**

(30) Priority: 28.06.2024 CN 202410870212
(71) Applicant: Beijing Zitiao Network Technology Co., Ltd., Beijing 100190 (CN)
(72) Inventor: Wang, Qi, Beijing 100028 (CN)
(74) Representative: Marks & Clerk LLP

(57) **Abstract**

Examples of the disclosure provide a switch circuit. The switch circuit comprises a first switch module (201), where the first switch module has a first end used to be connected to a first end of a path to be controlled, a second end used to be connected to a second end of the path to be controlled, and a control end used to receive a first control signal. A reverse conduction voltage of the first switch module is less than a preset voltage at the time of being turned off. The preset voltage is related to a voltage of a body diode of a standard silicon diode.

## Description

### FIELD

Examples of the disclosure relate to the technical field of battery charging, and in particular to a switch circuit, a circuit for protecting a battery, a method and circuit for controlling charging, and a charging system.

### BACKGROUND

The use of circuits for protecting a battery for battery protection is a key measure to ensure the stable operation and safety of battery cells.

In the related art, ordinary MOS field-effect transistors are generally used as discharge transistors and charge transistors in the circuits for protecting a battery.

However, the inventor found at least the following technical problems in the related art: it takes a long time from the time the battery enters an activation phase to the time of starting up, and the user experience is poor.

### SUMMARY

Examples of the disclosure provide a switch circuit, a circuit for protecting a battery, a method and circuit for controlling charging, and a charging system, so as to shorten time spent before starting up.

In a first aspect, the examples of the disclosure provide a switch circuit. The switch circuit includes a first switch module comprising a first end, a second end and a control end, the first end of the first switch module being used to be connected to a first end of a path to be controlled, the second end being used to be connected to a second end of the path to be controlled, and the control end being used to receive a first control signal;
the first switch module being used to be turned off under control of the first control signal, such that a forward conduction path of the path to be controlled is turned off; a reverse conduction voltage of the first switch module being less than a preset voltage at the time of being turned off; the preset voltage being related to a voltage of a body diode of a standard silicon diode; reverse conduction being that a current direction of the path to be controlled is from the second end to the first end of the path to be controlled, and forward conduction being that a current direction of the path to be controlled is from the first end to the second end of the path to be controlled.

In a second aspect, the examples of the disclosure provide a circuit for protecting a battery. The circuit for protecting a battery includes the switch circuit according to the first aspect.

In a third aspect, the examples of the disclosure provide a method for controlling battery charging, applied to a circuit for controlling charging. The circuit for controlling charging is used to charge a battery to be charged. The battery to be charged includes the circuit for protecting a battery according to the second aspect. The method includes:
detecting a voltage of the battery to be charged, and obtaining a current battery voltage; and
setting, in response to the current battery voltage being great than a fast charge threshold voltage, a charge current provided for the battery to be charged as a fast charge current value, where the fast charge threshold voltage is greater than or equal to a sum of a current voltage of a cell of the battery to be charged and a preset voltage corresponding to the circuit for protecting a battery.

In a fourth aspect, the examples of the disclosure provide a circuit for controlling charging. The circuit for controlling charging is connected to a battery to be charged. The battery to be charged includes the circuit for protecting a battery according to the second aspect.

The circuit for controlling charging detects a voltage of the battery to be charged and obtains a current battery voltage; and
the circuit for controlling charging is used to set, in response to the current battery voltage being great than a fast charge threshold voltage, a charge current provided for the battery to be charged as a fast charge current value, and the fast charge threshold voltage is greater than or equal to a sum of a current voltage of a cell of the battery to be charged and a preset voltage corresponding to the circuit for protecting a battery.

In a fifth aspect, the examples of the disclosure provides a system for charging a battery. The system for charging a battery includes the circuit for protecting a battery according to the second aspect and the circuit for controlling charging according to the third aspect.

The examples of the disclosure provide the switch circuit, the circuit for protecting a battery, the method and circuit for controlling charging, and the charging system. The switch circuit includes a first switch module, where the first switch module includes a first end, a second end and a control end, the first end of the first switch module is used to be connected to a first end of a path to be controlled, the second end is used to be connected to a second end of the path to be controlled, and the control end is used to receive a first control signal. The first switch module is used to be turned off under control of the first control signal, such that a forward conduction path of the path to be controlled is turned off. A reverse conduction voltage of the first switch module is less than a preset voltage at the time of being turned off. The preset voltage is related to a voltage of a body diode of a standard silicon diode. Reverse conduction is that a current direction of the path to be controlled is from the second end to the first end of the path to be controlled. Forward conduction is that a current direction of the path to be controlled is from the first end to the second end of the path to be controlled. By reducing the reverse conduction voltage of the first switch module to be lower than the preset voltage, compared with an ordinary metal-oxide-semiconductor (MOS) field-effect transistor, the switch circuit provided in the examples of the disclosure can reduce a difference between a battery voltage and an actual cell voltage when the battery enters a discharge protection state, such that a threshold voltage for fast charge can be reduced, a fast charge current can be used for charging earlier, charging time before starting up can be shortened, waiting time of a user can be reduced, and user experience can be improved.

### BRIEF DESCRIPTION OF THE DRAWINGS

In order to describe the technical solutions in examples of the disclosure or in the prior art more clearly, the accompanying drawings required for describing the examples or the prior art are briefly described below. Apparently, the accompanying drawings in the following description show some examples of the disclosure. Those of ordinary skill in the art can also derive other accompanying drawings from these accompanying drawings without inventive efforts.
Fig. 1a is a schematic structural diagram of a circuit for protecting a battery according to the prior art;
Fig. 1b is a schematic diagram showing the principle of a circuit for protecting a battery under a discharge protection state according to the prior art;
Fig. 2 is a schematic structural diagram of a switch circuit according to an example of the disclosure;
Fig. 3a is a schematic structural diagram of a third switch transistor of a switch circuit according to an example of the disclosure;
Fig. 3b is a schematic diagram of a forming range of a metal region of a third switch transistor of a switch circuit according to an example of the disclosure;
Fig. 4 is a schematic structural diagram of a second switch transistor of a second switch module according to an example of the disclosure;
Fig. 5 is a schematic diagram of a layout of an integrated circuit of a third switch transistor and a second switch transistor according to an example of the disclosure;
Fig. 6 is a schematic structural diagram of a circuit for protecting a battery according to an example of the disclosure;
Fig. 7 is a schematic flowchart of a method for controlling charging according to an example of the disclosure; and
Fig. 8 is a schematic structural diagram of a system for charging a battery according to an example of the disclosure.

### Reference numerals:

20: circuit for protecting a battery; 201: first switch module; 202: second switch module; 203: detection module; 301: substrate region; 302: gate structure; 303: first end doped region; 304: second end doped region; 305: metal region; 306: metal semiconductor junction; and 307: preset peripheral region.

### DETAILED DESCRIPTION OF EMBODIMENTS

In order to make the objectives, technical solutions, and advantages in examples of the disclosure clearer, the technical solutions in the examples of the disclosure are clearly and completely described below with reference to the accompanying drawings in the examples of the disclosure. Apparently, the examples described are some examples rather than all examples of the disclosure. Based on the examples of the disclosure, all other examples derived by those of ordinary skill in the art without creative efforts fall within the scope of protection of the disclosure.

Battery protection is a key measure to guarantee the safe and stable operation of batteries. Improper charge and discharge operations, extreme temperature and humidity conditions, and defects in the battery itself can lead to reduction in battery performance and shortened life, and even cause safety incidents such as fire or explosion. Thus as a core component of a battery management system, a battery protection plate is important to prevent these problems. The battery protection plate typically includes overcharge protection, over-discharge protection, overcurrent protection, temperature monitoring and other functions.

In an electronic device, such as a virtual reality (VR)/extended reality (XR) device, powered by a rechargeable battery, a user community more often use over-discharge protection of battery protection, and then recharges the battery for use.

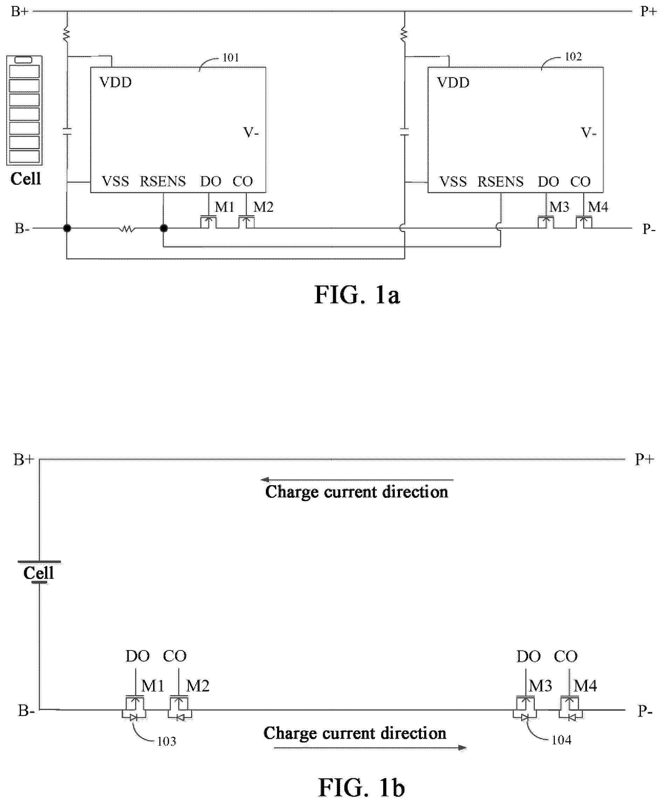

In the related art, a circuit for protecting a battery as shown in Fig. 1a is generally used. As shown in Fig. 1a, the circuit for protecting a battery includes two paths of protection circuits of path A and path B. The path A includes a corresponding detection chip A, a discharge transistor M1 and a charge transistor M2. The path B includes a corresponding detection chip B, a discharge transistor M3 and a charge transistor M4. In a process of cell discharge, B+/B- to be protected is connected to a cell end (B+ is connected to a positive electrode of the cell, an B- is connected to a negative electrode of the cell), is subjected to double protection through the two paths of protection circuits of path A and path B, and then is discharged to battery ends P+/P-for use by a system. In a process of cell charge, the battery end P+ is connected to a positive electrode of a charge power supply, and the battery end P- is connected to a negative electrode of the charge power supply. Double protection is carried out through the two paths of protection circuits of path A and path B, and then the cell end B+/B- is charged. Specifically, a chip A and a chip B may be identical in design. A DO signal output by a pin DOUT is used to control an on-off state of switch protection transistors, that is, discharge transistors M1 and M3, of a discharge path. A CO signal output by a pin COUT is used to control an on-off state of switch protection transistors, that is, charge transistors M2 and M4, of a charge path.

However, in the above battery protection manner, an activation speed of the battery and a speed of entering a fast charge phase after activation are low, requiring a user to spend long waiting time, and the user experience is poor.

In order to solve the above technical problems, the inventor of the present application has found that when a user uses the cell down to about 1.5 V, it takes a long time to charge for activation. One reason is that an activation current needs to be set relatively small from the perspective of safety of the cell during charge, and another reason is that it is relatively slow to enter fast charge from timing of entering the fast charge.

Specific research findings are as follows: a cell that is placed to 1.5 V by a user needs to go through the following three phases to be used normally:

### Phase 1: activation phase:

When a voltage of the battery is less than about 2.5 V, the battery needs to enter a discharge protection state, and only the cell and a protection chip (IC) are allowed to consume power. For battery safety, a charge current is generally less than 0.1 C during charge.

### Phase 2: precharge phase:

When the voltage of the battery is greater than about 2.5 V and less than 3 V, the battery is released from limitation of the discharge protection state, but the charge current is still required to remain small.

### Phase 3: fast charge phase:

When the voltage of the battery is greater than 3 V, the battery may be charged with a larger fast charge current, such as a 3C fast charge battery.

**Table 1**

| Behavior | Cell | Battery | Charge current | Consumed time |
|---|---|---|---|---|
| Activation phase | (1 V-1.5 V)-(2 V-2.5 V) | 2 V-3.5 V | 0.1 C | 10 mAh/0.1 * 3 Ah = 6 minutes (10 mAh is a capacity corresponding to the activation phase, and 3 Ah is a total capacity of the cell) |
| | | | | 2 minutes/0.5 V the cell changes |
| Precharge phase | 2.5 V-3 V | 2.5 V-3 V | 0.1 C | 5 mAh/0.1 * 3 Ah = 6 minutes (5 mAh is a capacity corresponding to the precharge phase, and 3 Ah is the total capacity of the cell) |
| Fast charge phase | > 3 V | > 3 V | 0.1 C | 5% * 3 Ah/0.1 * 3 Ah = 30 minutes (5% is a ratio of the corresponding capacity to the total capacity, 3 Ah is the total capacity of the cell) |
| | > 3.5 V | > 3.5 V | 3 C | |
| Start up | 3.5 V | 3.6 V | 3 C | Starting up may be performed until the voltage of the battery reaches to a value. |

So for a deep user, in a case that a device is placed for a long time, the voltage of the cell is low due to a loss of power, such as the cell is discharged to about 2 V. It takes 2 minutes + 6 minutes + 30 minutes = 38 minutes for the user to charge the battery before the device can start up normally. The experience is poor.

Thus as shown in the above table and Fig. 1b, it can be concluded that the battery takes long time from activation to fast charge mainly because a voltage drop of a diode in an activation path of the protection circuit provided in Fig. 1a is too large.

Specifically, as shown in Fig. 1a, in the activation phase: voltage of the battery = voltage of the cell + 2 * voltage drop of the body diode of the switch transistor.

A constant current source is supplied to the battery during activation, due to discharge protection of the battery, the discharge transistors (M1 and M3) are turned off, and the charge transistors (M2 and M4) are turned on, such that a current flows in the positive electrode P+ of the battery first, passes through the cell, then passes through body diodes (103 and 104) of the two discharge transistors (M1 and M3), and flows back to the negative electrode P- of the battery.

The voltage drop of the body diodes of the two switch transistors is about 0.9 V-1 V.

Then when the battery is activated to 3V, the corresponding cell has two states:
In the first state, the cell is still not activated, and the corresponding cell has a voltage of 3 - 1V = 2 V.

In the second state, the discharge transistors (M1 and M3) are turned on after the activation of the cell, and the corresponding cell has a voltage of 3 V.

Since the voltage of the battery is generally collected in the activation phase, for the safety of the battery the voltage of the battery needs to exceed 3 V when entering the fast charge phase, and the battery needs to be released from discharge protection. Due to an influence of the cell in the discharge protection state, an earliest timing to enter fast charge is 2.5 V (battery protection release point) + 1 V (2 diode voltage drop) = 3.5 V

Then it will lead to that a region of 3 V- 3.5 V cannot use fast charge to save charge time, and can only use a precharge pattern in the precharge phase.

After the above reasons are studied and determined, the inventor found that how to reduce a reverse conduction voltage drop when the discharge transistors (for example, M1 and M3) are turned off is the key to solve the problem. Based on this, the examples of the disclosure provide a switch circuit, a circuit for protecting a battery, a method and system for controlling charging, and a charging system.

Illustratively, assuming that the reverse conduction voltage drop of the discharge transistors (M1 and M3) drops down to about 0.2 V in the activation phase, a charge improvement is described in detail in conjunction with charge policies shown in Table 2. For example, a voltage drop of a body diode of a switch transistor is reduced by changing a type of a protection switch. For example, a switch transistor integrated circuit (IC) with a pin led out from a drain D may be selected. A diode (such as a Schottky diode) is connected in parallel to the IC externally to reduce the reverse conduction voltage drop of the discharge transistor, that is, the voltage drop of the body diode.

Transitions of the charge policies are shown in Table 2:

**Table 2**

| Behavior | Cell | Battery | Charge current | Consumed time |
|---|---|---|---|---|
| Activation phase | (1 V-1.5 V)-(2 V-2.5 V) | 1.4 V-2.9 V | 0.1 C | 10 mAh/0.1 * 3 Ah = 6 minutes (10 mAh is a capacity corresponding to the activation phase, and 3 Ah is a total capacity of the cell) |
| | | | | 2 minutes/0.5 V the cell changes |
| Precharge phase | 2.5 V-3 V | 2.5 V-3 V | 0.1 C | 5 mAh/0.1 * 3 Ah = 6 minutes (5 mAh is a capacity corresponding to the precharge phase, and 3 Ah is the total capacity of the cell) |
| Fast charge phase | > 3 V | > 3 V | 3 C | 5% * 3 Ah/3 * 3 Ah = 1 minutes (5% is a ratio of the corresponding capacity to the total capacity, 3 Ah is the total capacity of the cell) |
| | > 3.5 V | > 3.5 V | 3 C | |
| Start up | 3.5 V | 3.6 V | 3 C | Starting up may be performed until the voltage of the battery reaches to a certain value. |

Assume that the device is also placed for a long time, for example, the cell is placed to about 2 V. It takes 2 minutes + 6 minutes +1 minutes = 9 minutes for the user to charge the battery before the device can start up normally. The user has a good experience. It is about a quarter of the 38 minutes that the prior art consumes.

The technical solutions of the present application are described in detail below with reference to specific examples. The following specific examples may be combined with each other, and the same or similar concepts or processes may not be repeated in some examples.

The examples of the disclosure provides a switch circuit. The switch circuit includes a first switch module comprising a first end, a second end and a control end, the first end of the first switch module being used to be connected to a first end of a path to be controlled, the second end being used to be connected to a second end of the path to be controlled, and the control end being used to receive a first control signal;

the first switch module being used to be turned off under control of the first control signal, such that a forward conduction path of the path to be controlled is turned off; a reverse conduction voltage of the first switch module being less than a preset voltage at the time of being turned off; the preset voltage being related to a voltage of a body diode of a standard silicon diode; reverse conduction being that a current direction of the path to be controlled is from the second end to the first end of the path to be controlled, and forward conduction being that a current direction of the path to be controlled is from the first end to the second end of the path to be controlled.

The path to be controlled is used to obtain a forward current from the first end to the second end of the path to be controlled through the forward conduction path when the first switch module is turned on. The reverse conduction voltage is a voltage drop when a reverse current flowing from the second end to the first end of the path to be controlled flows through the first switch module.

By reducing the reverse conduction voltage of the first switch module to be lower than the preset voltage, compared with an ordinary metal-oxide-semiconductor (MOS) field-effect transistor, the switch circuit provided in the examples of the disclosure can reduce a difference between a battery voltage and an actual cell voltage when the battery enters a discharge protection state, such that a threshold voltage for fast charge can be reduced, a fast charge current can be used for charging earlier, charging time before starting up can be shortened, waiting time of a user can be reduced, and user experience can be improved.

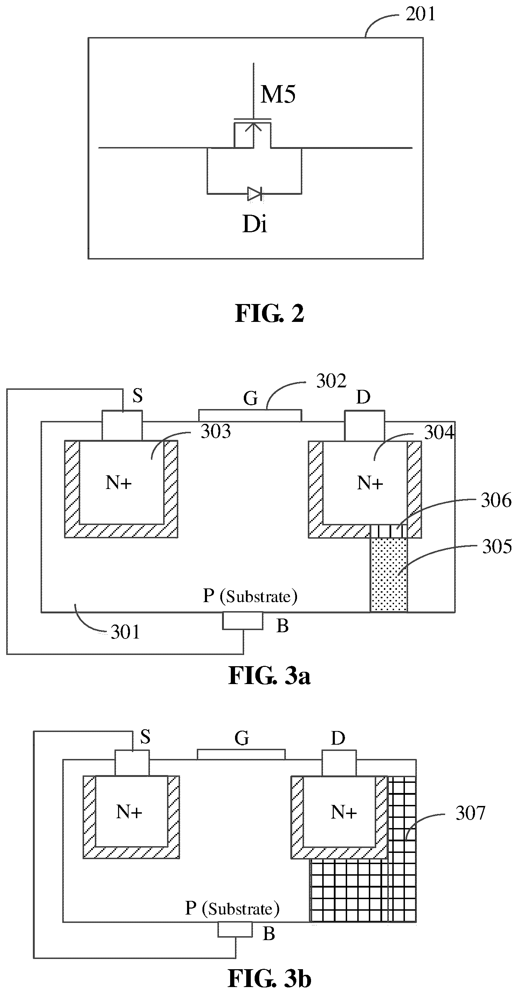

With reference to Fig. 2, Fig. 2 is a schematic structural diagram of a switch circuit according to an example of the disclosure. As shown in Fig. 2, the first switch module 201 includes a first switch transistor M5 and a diode Di.

The first switch transistor M5 includes a first end, a second end and a control end. The first end of the first switch transistor M5 is used to be connected to the first end of the path to be controlled. The second end of the first switch transistor M5 is used to be connected to the second end of the path to be controlled. The control end of the first switch transistor M5 is used to receive a control signal.

An anode of the diode Di is connected to the first end of the first switch transistor M5, and a cathode is connected to the second end of the first switch transistor M5.

In the example of the disclosure, the diode Di may be a Schottky diode.

In the example of the disclosure, the first end of the first switch transistor M5 is a source S, the second end is a drain D, and the control end is a gate G.

In the example of the disclosure, the first switch module 201 may be obtained by using an existing switch transistor IC. For example, a switch transistor IC with a pin led out from the drain D may be selected. The diode Di is connected in parallel to the IC externally to reduce the reverse conduction voltage drop of the discharge transistor, that is, the voltage drop of the body diode.

In an example of the disclosure, the first switch transistor M5 and the diode Di may be packaged in one device to reduce a footprint.

With reference to Fig. 3a, Fig. 3a is a schematic structural diagram of a third switch transistor of a switch circuit according to an example of the disclosure. In an example of the disclosure, the first switch module includes a third switch transistor. The third switch transistor is integrated with a metal semiconductor junction 306. The reverse conduction voltage is related to a conduction voltage of the metal semiconductor junction 306. A first end of the third switch transistor is connected to the first end of the path to be controlled. A second end of the third switch transistor is connected to the second end of the path to be controlled. A control end of the third switch transistor is used to receive the first control signal.

The third switch transistor is a metal-oxide-semiconductor field effect transistor (MOSFET).

Specifically, the metal semiconductor junction 306 is used to form the reverse conduction voltage. When the first switch module is conducted in a reverse direction, the third switch transistor is turned on in a reverse direction. When the third switch transistor is turned on in a reverse direction, the metal semiconductor junction 306 is turned on in a reverse direction. The reverse conduction voltage of the first switch module is a voltage between the first end and the second end when the third switch transistor is turned on in a reverse direction.

As shown in Fig. 3a, the third switch transistor includes a substrate region 301, a gate structure 302 for leading out the control end, a first end doped region 303 for leading out the first end, a second end doped region 304 for leading out the second end, and a metal region 305.

The gate structure 302 is formed on the substrate region 301. The first end doped region 303 is formed in the substrate region 301 on a side of the gate structure 302. The second end doped region 304 is formed in the substrate region 301 on another side of the gate structure 302. The metal region 305 is formed in the substrate region 301 in a preset peripheral region of the second end doped region 304. The metal semiconductor junction 306 is formed between the metal region 305 and the second end doped region 304.

In an example of the disclosure, in order to reduce an influence on operating parameters of the third switch transistor when the third switch transistor is normally turned on, a cross-sectional area of the metal region 305 in a direction perpendicular to a section of the substrate region is less than a cross-sectional area of the second end doped region 304 in a direction perpendicular to a section of the substrate region.

In an example of the disclosure, as shown in Fig. 3b, in order to reduce the influence on the operating parameters of the third switch transistor when the third switch transistor is normally turned on, the preset peripheral region 307 is located below the second end doped region 304 or on a side of the second end doped region away from the gate structure 302.

In an example of the disclosure, the switch circuit further includes a second switch module. The second end of the first switch module is connected to the second end of the path to be controlled by means of the second switch module. A control end of the second switch module is used to receive a second control signal. The second switch module is used to be turned on under control of the second control signal, so as to control a reverse path of the path to be controlled to be turned on. A reverse current from the second end to the first end of the circuit to be controlled is obtained.

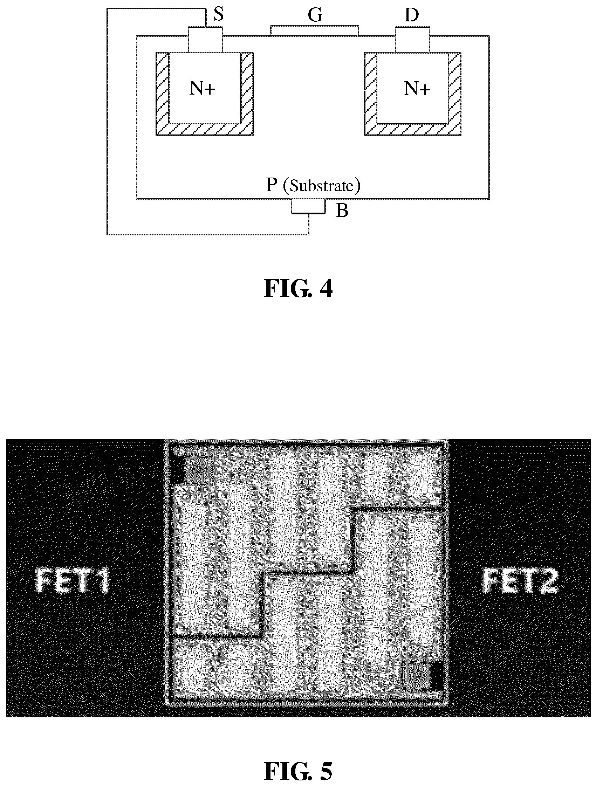

The second switch module includes a second switch transistor. The second end of the first switch module is connected to the second end of the path to be controlled by means of the second switch transistor, and a control end of the second switch transistor is used to receive the second control signal. As shown in Fig. 4, the second switch transistor may include a substrate region, a gate structure, a doped region corresponding to the first end S, and a doped region corresponding to the second end D. No metal region is included.

In an example of the disclosure, the first switch module and the second switch module are integrated together. Specifically, the third switch transistor in the first switch module is integrated with the second switch transistor in the second switch module. Illustratively, a layout shown in Fig. 5 may be used.

The examples of the disclosure further provide a circuit for protecting a battery. The circuit for protecting a battery includes the switch circuit according to the above examples.

By reducing the reverse conduction voltage of the first switch module to be lower than the preset voltage, compared with an ordinary MOS field-effect transistor, the circuit for protecting a battery provided in the examples of the disclosure can reduce a difference between a battery voltage and an actual cell voltage when the battery enters a discharge protection state, such that a threshold voltage for fast charge can be reduced, a fast charge current can be used for charging earlier, charging time before starting up can be shortened, waiting time of a user can be reduced, and user experience can be improved.

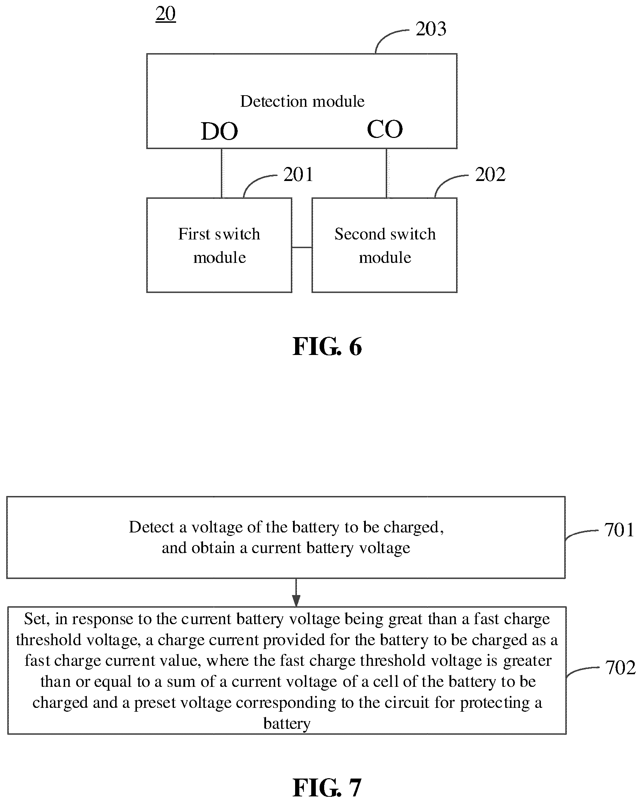

In an example of the disclosure, as shown in Fig. 6, the circuit for protecting a battery 20 includes: a detection module 203, a first switch module 201, and a second switch module 202. A first end of the first switch module 201 is connected to a first end of a cell in a battery to be protected. A second end of the first switch module 201 is connected to a second end of the second switch module 202. A first end of the second switch module 202 is connected to a first end of the battery to be protected. A control end of the first switch module 201 is connected to an output end of the detection module 203. The detection module 203 is used to detect electrical parameters of the cell, and generate a first control signal and a second control signal according to detection results. The first switch module 201 is used to be turned off under control of the first control signal, so as to control a discharge path of the battery to be protected to be turned off. A reverse conduction voltage of the first switch module 201 turned off is less than a preset voltage. The preset voltage is related to a voltage of a body diode of a standard silicon diode. The second switch module 202 is used to be turned on under control of the second control signal, so as to control a charge path of the battery to be protected to be turned on.

The electrical parameters of the cell may be a voltage and/or a current. The detection module 203 may detect whether the voltage of the cell exceeds an overvoltage charge protection threshold and an overvoltage discharge protection threshold, and may also detect whether the current of the cell exceeds an overcurrent charge protection threshold and an overcurrent discharge protection threshold.

In the example of the disclosure, the first switch module 201 and the second switch module 202 may be separate devices or an integrated device.

In an example of the disclosure, the first end of the cell in the battery to be protected is a negative electrode of the cell, and the first end of the battery to be protected is a negative electrode of the battery to be protected. The first switch module 201 includes a first switch transistor and a diode. A first end of the first switch transistor is connected to the negative electrode of the cell in the battery to be protected. A second end of the first switch transistor is connected to a second end of the second switch module 202. A control end of the first switch transistor is connected to the output end of the detection module 203. An anode of the diode is connected to the first end of the first switch transistor, and a cathode of the diode is connected to the second end of the first switch transistor.

In the example of the disclosure, the first switch transistor and the diode may be separate devices, or may be packaged independently or together. Moreover, the first switch transistor of the first switch module 201 and the second switch transistor of the second switch module 202 may be integrated together, and the drain D is led out. The diode is connected in parallel to the first switch transistor through the D.

In an example of the disclosure, the first switch module 201 includes a third switch transistor. The third switch transistor is integrated with a metal semiconductor junction. The reverse conduction voltage is related to a conduction voltage of the metal semiconductor junction. A first end of the third switch transistor is connected to the negative electrode of the cell in the battery to be protected. A second end of the third switch transistor is connected to the second end of the second switch module 202. A control end of the third switch transistor is connected to the output end of the detection module 203.

In an example of the disclosure, the third switch transistor is a metal-oxide semiconductor field effect transistor (MOSFET). The third switch transistor includes a substrate region, a gate structure for leading out the control end, a first end doped region for leading out the first end, a second end doped region for leading out the second end, and a metal region. The gate structure is formed on the substrate region. The first end doped region is formed in the substrate region on a side of the gate structure. The second end doped region is formed in the substrate region on another side of the gate structure. The metal region is formed in the substrate region in a preset peripheral region of the second end doped region. The metal semiconductor junction is formed between the metal region and the second end doped region.

In an example of the disclosure, a cross-sectional area of the metal region in a direction perpendicular to a section of the substrate region is less than a cross-sectional area of the second end doped region in a direction perpendicular to a section of the substrate region.

In an example of the disclosure, the preset peripheral region is located below the second end doped region or on a side of the second end doped region away from the gate structure.

In an example of the disclosure, the first switch module 201 and the second switch module 202 are integrated together.

For the third switch transistor in the above example, reference may be made to the description of the example shown in Figs. 3a and 3b, which is not repeated herein.

With reference to Fig. 7, Fig. 7 is a schematic flowchart of a method for controlling battery charging according to an example of the disclosure. The method for controlling battery charging is applied to a circuit for controlling charging. The circuit for controlling charging is used to charge a battery to be charged. The battery to be charged includes the circuit for protecting a battery according to the above examples. As shown in Fig. 7, the method includes:
701, a voltage of the battery to be charged is detected, and a current battery voltage is obtained.
702, in response to the current battery voltage being great than a fast charge threshold voltage, a charge current provided for the battery to be charged is set as a fast charge current value, where the fast charge threshold voltage is greater than or equal to a sum of a current voltage of a cell of the battery to be charged and a preset voltage corresponding to the circuit for protecting a battery.

By reducing the reverse conduction voltage of the first switch module to be lower than the preset voltage, compared with an ordinary MOS field-effect transistor, the method for controlling battery charging provided in the examples of the disclosure can reduce a difference between a battery voltage and an actual cell voltage when the battery enters a discharge protection state, such that a threshold voltage for fast charge can be reduced, a fast charge current can be used for charging earlier, charging time before starting up can be shortened, waiting time of a user can be reduced, and user experience can be improved.

In an example of the disclosure, the method further includes: in response to the current battery voltage being greater than a precharge threshold voltage and less than the fast charge threshold voltage, the charge current is set to a first current value; and in response to the current battery voltage being greater than an activation threshold voltage and less than the precharge threshold voltage, the charge current is set to a second current value, where the first current value and the second current value are both less than the fast charge current value.

The examples of the disclosure further provide a circuit for controlling charging. The circuit for controlling charging is connected to a battery to be charged. The battery to be charged includes the circuit for protecting a battery according to the above examples. The circuit for controlling charging detects a voltage of the battery to be charged and obtains a current battery voltage. The circuit for controlling charging is used to set, in response to the current battery voltage being great than a fast charge threshold voltage, a charge current provided for the battery to be charged as a fast charge current value. The fast charge threshold voltage is greater than or equal to a sum of a current voltage of a cell of the battery to be charged and a preset voltage corresponding to the circuit for protecting a battery.

In an example of the disclosure, the circuit for controlling charging is further used to set, in response to the current battery voltage being greater than a precharge threshold voltage and less than the fast charge threshold voltage, the charge current to a first current value; and the circuit for controlling charging is further used to set, in response to the current battery voltage being greater than a precharge threshold voltage and less than the fast charge threshold voltage, the charge current to a first current value. The circuit for controlling charging is further used to set, in response to the current battery voltage being greater than an activation threshold voltage and less than the precharge threshold voltage, the charge current to a second current value. The first current value and the second current value are both less than the fast charge current value.

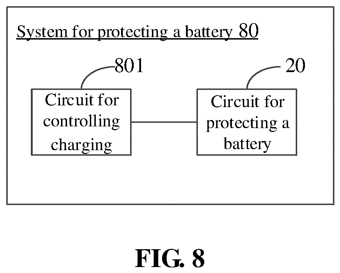

With reference to Fig. 8, Fig. 8 is a schematic structural diagram of a system for charging a battery according to an example of the disclosure. The system for charging a battery 80 includes the circuit for protecting a battery 20 according to the above examples and the circuit 801 for controlling charging according to the above examples.

Reference may be made to the above examples for working principles of the circuit for protecting a battery 20 and the circuit 801 for controlling charging, which is not repeated herein.

By reducing the reverse conduction voltage of the first switch module to be lower than the preset voltage, compared with an ordinary MOS field-effect transistor, the system for charging a battery provided in the examples of the disclosure can reduce a difference between a battery voltage and an actual cell voltage when the battery enters a discharge protection state, such that a threshold voltage for fast charge can be reduced, a fast charge current can be used for charging earlier, charging time before starting up can be shortened, waiting time of a user can be reduced, and user experience can be improved.

The above description is merely illustrative of preferred examples of the disclosure and principles of the technology employed. It should be understood by those skilled in the art that the disclosed scope involved in the disclosure is not limited to the technical solutions in which the above-described technical features are specifically combined, but encompasses other technical solutions in which the above-described technical features or equivalent features thereof are arbitrarily combined without departing from the concept of the disclosure, for example, technical solutions formed by interchanging the features described above with (non-limitative) technical features disclosed in the disclosure that have similar functions.

Furthermore, although operations are depicted in a particular order, this should not be understood as requiring that such operations be executed in the particular order shown or in a sequential order. In certain circumstances, multitasking and parallel processing may be advantageous. Similarly, although several specific implementation details are included in the above discussion, these details should not be construed as limitation to the scope of the disclosure. Some features that are described in the context of separate examples may also be implemented in combination in a single example. On the contrary, various features described in the context of a single example can also be implemented in multiple examples separately or in any suitable sub-combination manner.

Although the subject matter has been described in language specific to structural features and/or methodological logical actions, it should be understood that the subject matter defined in the appended claims is not necessarily limited to the specific features or actions described above. On the contrary, the specific features and actions described above are merely instance forms of implementing the claims.

## Claims

1. A switch circuit, comprising:
a first switch module (201) comprising a first end, a second end and a control end, the first end of the first switch module being used to be connected to a first end of a path to be controlled, the second end being used to be connected to a second end of the path to be controlled, and the control end being used to receive a first control signal;
the first switch module being used to be turned off under control of the first control signal, such that a forward conduction path of the path to be controlled is turned off; a reverse conduction voltage of the first switch module being less than a preset voltage at the time of being turned off; the preset voltage being related to a voltage of a body diode of a standard silicon diode; reverse conduction being that a current direction of the path to be controlled is from the second end to the first end of the path to be controlled, and forward conduction being that a current direction of the path to be controlled is from the first end to the second end of the path to be controlled.

2. The circuit of claim 1, wherein the first switch module comprises a first switch transistor and a diode, and a conduction voltage of the diode is less than the preset voltage;
the first switch transistor comprises a first end, a second end and a control end, the first end of the first switch transistor is used to be connected to the first end of the path to be controlled, the second end of the first switch transistor is used to be connected to the second end of the path to be controlled, and the control end of the first switch transistor is used to receive a control signal; and
an anode of the diode is connected to the first end of the first switch transistor, and a cathode of the diode is connected to the second end of the first switch transistor.

3. The circuit of claim 2, wherein the diode is a Schottky diode.

4. The circuit of claim 1, wherein the first switch module comprises a third switch transistor, the third switch transistor is integrated with a metal semiconductor junction, and the reverse conduction voltage is related to a conduction voltage of the metal semiconductor junction; and
a first end of the third switch transistor is connected to the first end of the path to be controlled, a second end of the third switch transistor is connected to the second end of the path to be controlled, and a control end of the third switch transistor is used to receive the first control signal.

5. The circuit of claim 4, wherein the third switch transistor is a metal-oxide semiconductor field effect transistor (MOSFET), and the third switch transistor comprises a substrate region, a gate structure for leading out the control end, a first end doped region for leading out the first end, a second end doped region for leading out the second end, and a metal region; and
the gate structure is formed on the substrate region, the first end doped region is formed in the substrate region on a side of the gate structure, the second end doped region is formed in the substrate region on another side of the gate structure, the metal region is formed in the substrate region in a preset peripheral region of the second end doped region, and the metal semiconductor junction is formed between the metal region and the second end doped region.

6. The circuit of claim 5, wherein a cross-sectional area of the metal region in a direction perpendicular to a section of the substrate region is less than a cross-sectional area of the second end doped region in the direction perpendicular to the section of the substrate region.

7. The circuit of claim 5, wherein the preset peripheral region is located below the second end doped region or on a side of the second end doped region away from the gate structure.

8. The circuit of any one of claims 1-7, wherein the switch circuit further comprises a second switch module;
the second end of the first switch module is connected to the second end of the path to be controlled by means of the second switch module, and a control end of the second switch module is used to receive a second control signal; and
the second switch module is used to be turned on under control of the second control signal to control a reverse path of the path to be controlled to be turned on.

9. The circuit of claim 8, wherein the first switch module and the second switch module are integrated together.

10. A circuit for protecting a battery (20), comprising the switch circuit of any of claims 1-9.

11. A method for controlling battery charging, applied to a circuit for controlling charging, wherein the circuit for controlling charging is used to charge a battery to be charged, the battery to be charged comprises the circuit for protecting a battery of claim 10, and the method comprises:
detecting (701) a voltage of the battery to be charged, and obtaining a current battery voltage; and
setting (702), in response to the current battery voltage being great than a fast charge threshold voltage, a charge current provided for the battery to be charged as a fast charge current value, wherein the fast charge threshold voltage is greater than or equal to a sum of a current voltage of a cell of the battery to be charged and a preset voltage corresponding to the circuit for protecting a battery.

12. The method of claim 11, further comprising:
setting, in response to the current battery voltage being greater than a precharge threshold voltage and less than the fast charge threshold voltage, the charge current to a first current value; and
setting, in response to the current battery voltage is greater than an activation threshold voltage and less than the precharge threshold voltage, the charge current to a second current value, wherein the first current value and the second current value are both less than the fast charge current value.

13. A circuit for controlling charging (801), connected to a battery to be charged, wherein the battery to be charged comprises the circuit for protecting a battery of claim 10;
the circuit for controlling charging detects a voltage of the battery to be charged and obtains a current battery voltage; and
the circuit for controlling charging is used to set, in response to the current battery voltage being great than a fast charge threshold voltage, a charge current provided for the battery to be charged as a fast charge current value, and the fast charge threshold voltage is greater than or equal to a sum of a current voltage of a cell of the battery to be charged and a preset voltage corresponding to the circuit for protecting a battery.

14. The circuit of claim 13, wherein
the circuit for controlling charging is further used to set, in response to the current battery voltage being greater than a precharge threshold voltage and less than the fast charge threshold voltage, the charge current to a first current value; and
the circuit for controlling charging is further used to set, in response to the current battery voltage being greater than an activation threshold voltage and less than the precharge threshold voltage, the charge current to a second current value, and the first current value and the second current value are both less than the fast charge current value.

15. A system for charging a battery (80), comprising the circuit for protecting a battery of claim 10 and the circuit for controlling charging of claim 13 or 14.
